# EUROPÄISCHE PATENTSCHRIFT

(11) **EP 2 107 673 B1**
(45) Veröffentlichungstag und Bekanntmachung des Hinweises auf die Patenterteilung: **06.03.2019**
(21) Anmeldenummer: 08006392.8
(22) Anmeldetag: 31.03.2008
(51) Int. Cl.: H02M 3/07, B60R 21/017

(54) **MOSFET als elektronischer AUS-Schalter**
MOSFET as electronic off-switch
MOSFET en tant que commutateur d'extinction électronique

(43) Veröffentlichungstag der Anmeldung: 07.10.2009
(73) Patentinhaber: Eberspächer Controls Landau GmbH & Co. KG, 76829 Landau (DE)
(72) Erfinder: Uhl, Günter, Dr.-Ing., 74921 Helmstadt-Bergen (DE); Wandres, Steffen, 76870 Kandel (DE)
(74) Vertreter: Grünecker Patent- und Rechtsanwälte PartG mbB

(56) Entgegenhaltungen:
- DE-A1- 19 639 701
- GB-A- 2 321 141
- JP-A- 2003 168 963

## Beschreibung

Die vorliegende Erfindung bezieht sich auf elektrische Trennschalter für das Bordnetz von Kraftfahrzeugen.

Im modernen Kfz-Bordnetzen besteht immer mehr die Aufgabe, das komplette Bordnetz, also alle elektrischen Verbraucher im Fahrzeug, oder Teilbereiche des Bordnetzes von einer Energiequellen zu trennen oder zwischen verschiedenen Energiequellen hin- und herzuschalten. Diese Energiequellen können der Generator, die Batterie oder ein Kondensator hoher Kapazität (Bezeichnung EDLC, Ultra-Cap oder SuperCap) sein. Dabei sind häufig Ströme von 100 A bis 300 A oder mehr zu schalten.

Mögliche Anwendungen sind z.B. ein Batterietrennschalter oder ein zweifacher Trennschalter, der zwischen zwei Batterien hin- und her schaltet.

Ein Batterietrennschalter hat die Aufgabe, ausgelöst durch ein Steuersignal, die Batterie vom restlichen Fahrzeug-Bordnetz zu trennen. Dies ist vor allem dann erforderlich, wenn die Batterie im Heck des Fahrzeuges installiert ist und über ein Kabel mit großem Querschnitt (90 mm² und mehr) mit dem Generator und Starter im Motorraum verbunden ist. Durch das Abtrennen der Batterie wird in einem Crash-Fall verhindert, dass es bei einer Beschädigung dieses Kabels zu einem Kurzschluss kommt, in dessen Folge ein Fahrzeugbrand auftreten kann. Herkömmlich werden als Batterietrennschalter meist pyrotechnisch oder elektromagnetisch betätigte Schalter eingesetzt.

Ein Trennschalter zur Bordnetzstabilisierung wird in zukünftigen Bordnetzen eingesetzt, um bei Spannungseinbrüchen im Bordnetz (ausgelöst z.B. durch den Startvorgang des Verbrennungsmotors in Verbindung mit einer Start-Stopp-Automatik) das gesamte Bordnetz kurzzeitig von dem Hauptenergiespeicher auf einen (kleinen) Hilfsenergiespeicher umzuschalten.

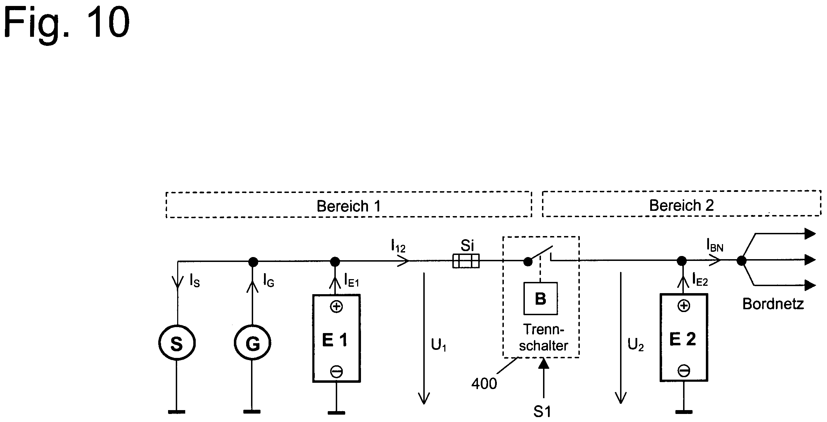

Figur 10 zeigt ein Beispiel für ein Kfz-Bordnetz, das mit Hilfe eines konventionellen Trennschalters 400 in zwei Bereiche aufgeteilt wird. Über ein Ansteuersignal S1 wird der Trennschalter geöffnet bzw. geschlossen. Bei laufendem Verbrennungsmotor wird die im Fahrzeug benötigte elektrische Leistung durch den Generator G erzeugt. Der Trennschalter ist geschlossen, d.h. die Bereiche 1 und 2 sind elektrisch miteinander verbunden. Der vom Generator erzeugte Strom I_{G} lädt die beiden Energiespeicher E1 und E2 und versorgt das Bordnetz. Bei stehendem Verbrennungsmotor wird vor Einleitung des Startvorgangs der Trennschalter geöffnet, d.h. die Bereiche 1 und 2 werden elektrisch voneinander getrennt. Der Energiespeicher E1 liefert dann den zum Antreiben des Starters S benötigten Strom I_{S}.

Konventionell werden derartige Trennschalter mit Relais, also elektromagnetisch betätigten Schaltern, realisiert. Der Einsatz von pyrotechnisch oder elektromagnetisch betätigten Schalter in solchen Anwendungen hat jedoch eine Reihe von Nachteilen.

So kann zum Beispiel ein pyrotechnisch betätigter Schalter nur einmal betätigt werden. Die elektrische Verbindung ist dann unwiderruflich getrennt; eine Wiederinbetriebnahme ist nicht mehr möglich. Der pyrotechnisch betätigte Schalter muss in einer Fachwerkstatt ausgetauscht werden. Einen pyrotechnisch Trennschalter wird man daher nur zur Abtrennung der Batterie im Crash-Fall einsetzen, da ein Wiedereinschalten nicht möglich ist.

Elektromagnetisch betätigte Schalter (Relais) haben nur eine begrenzte Lebensdauer. Die Anzahl der mögliche Schaltzyklen unter Last ist begrenzt und ist umso kleiner je höher die Schaltströme sind. Dieser Verschleiß macht es erforderlich, den Schalter nach einer bestimmten Zeit auszutauschen.

Weiterhin ist das zeitliche Schaltverhalten von elektromagnetisch betätigten Schaltern ungünstig, da beim Schließen der Kontakte ein Kontaktprellen auftritt und da zwischen dem Ansteuern des Schalters und dem Öffnen oder Schließen der Kontakte eine nur wenig definierte zeitliche Verzögerung von mehreren Millisekunden bis ca. 100 ms vorhanden ist. Dies ist insbesondere dann ungünstig, wenn zwei elektromagnetisch betätigte Schalter zum Umschalten zwischen zwei Energiespeichern (der eine Schalter öffnet, der andere schließt) zeitgleich betätigt werden müssen. Wegen des zeitlich nicht genau definierten Schaltens muss man den zweiten Schalter zunächst schließen bevor man den ersten Schalter öffnet ("make before break"). Es treten dabei hohe Ausgleichsströme auf, die die Kontakte zusätzlich belasten und verschleißen.

Es gibt daher Bestrebungen, derartige pyrotechnisch oder elektromagnetisch betätigte Schalter durch mit Hilfe von Transistoren realisierte Halbleiterschalter zu ersetzen.

Für derartige Halbleiterschalter bestehen jedoch eine Reihe wichtiger Anforderungen. So ist beispielsweise bei einem Trennschalter der Grund- bzw. Ruhezustand der Zustand EIN. Erst durch eine externes Steuersignal geht der Schalter in den Zustand AUS und unterbricht den Stromfluss. Der Zustand AUS ist ein seltener Zustand und darf auf keinen Fall ungewollt auftreten. Außerdem muss der Schalter hohe Ströme schalten, so dass er im Zustand EIN einen sehr geringen Einschaltwiderstand Rₒₙ aufweisen muss, damit der Spannungsabfall über dem Schalter und damit die im Schalter umgesetzte Verlustleistung gering bleiben. Schließlich darf nur eine sehr geringe Ansteuerleistung benötigt werden, um den elektronischen Schalter im Zustand EIN zu halten.

Aus der Druckschrift EP 1 600 337 A ist ein elektronischer Batterietrennschalter bekannt, der eine sichere und reversible Trennung des Kraftfahrzeugbordnetzes von der Batterie ermöglicht. Zu diesem Zweck wird als Halbleiterschalter ein so genannter MOSFET im Inversbetrieb verwendet, der eine unbegrenzte Anzahl von Schaltzyklen ermöglicht. Der Batterietrennschalter trennt die elektrische Verbindung des Kraftfahrzeugbordnetzes und der Batterie bei Vorliegen eines Crash-Signals, eines Überstrom-Signals oder dem Ausschalten der Zündung. Bei abgestelltem Fahrzeug kann dann sicher ein unzulässig hoher Ruhestrom und eine Entladung der Batterie effektiv und in einfacher Weise verhindert werden.

Ein derartiger Trennschalter lässt jedoch noch Wünsche offen, insbesondere hinsichtlich der zur Ansteuerung erforderlichen Leistung.

Aus der Druckschrift JP 2003/168963 A ist ein Halbleiterschalter bekannt, der einen Strom durch eine Last schaltet und über eine Ladungspumpe angesteuert wird. Die Ladungspumpe wird dabei intermittierend betrieben, um einen unnötigen Stromverbrauch zu vermeiden. Der intermittierende Betrieb der Ladungspumpe kann dabei entweder spannungsgesteuert oder zeitgesteuert erfolgen. Bei diesem Halbleiterschalter muss jedoch für einen Einsatz in einem Kfz die Zuverlässigkeit und Sicherheit zunächst noch verbessert werden.

Ziel der vorliegenden Erfindung ist es daher, einen elektronischen Trennschalter für Kfz-Bordnetze anzugeben, der sich durch hohe Zuverlässigkeit und geringe Ansteuerleistungsaufnahme auszeichnet.

Dies wird durch die Merkmale der unabhängigen Ansprüche erreicht. Bevorzugte Ausführungsformen sind Gegenstand der abhängigen Ansprüche.

Gemäß einem zweiten Aspekt der vorliegenden Erfindung wird ein Bordnetz für ein Kraftfahrzeug mit einem ersten Bereich und einem davon trennbaren zweiten Bereich zur Verfügung gestellt, wobei der erste Bereich einen Energiespeicher umfasst, der zweite Bereich mit mindestens einem Verbraucher verbunden ist, und der erste Bereich und der zweite Bereich des Bordnetzes über einen Trennschalter gemäß dem ersten Aspekt der Erfindung verbunden sind.

Gemäß einem dritten Aspekt der vorliegenden Erfindung wird ein Verfahren zur reversiblen Trennung eines Kfz-Bordnetzes in einen ersten Bereich und einen zweiten Bereich, wobei der erste Bereich einen Energiespeicher umfasst und der zweite Bereich mit mindestens einem Verbraucher verbunden ist, zur Verfügung gestellt.

Vorteilhafterweise aktiviert oder deaktiviert die Steuerschaltung des Trennschalters die Ladungspumpe in Abhängigkeit von der Höhe der Gate-Source-Spannung des Halbleiterschalters. Vorzugsweise überwacht die Steuerschaltung die Gate-Spannung des Halbleiterschalters und aktiviert die Ladungspumpe, wenn die Gate-Spannung unter einen vorbestimmten Minimalwert fällt. Dadurch kann sichergestellt werden, dass die Gate-Spannung nicht unter den für eine vollständige Durchsteuerung des Halbleiterschalters erforderlichen Wert abfällt. Darüber hinaus kann die Steuerschaltung die Gate-Spannung des Halbleiterschalters überwachen und die Ladungspumpe deaktivieren, wenn die Gate-Spannung einen vorbestimmten Maximalwert überschreitet. Auf diese Weise kann die durch die Ladungspumpe verursachte Verlustleistung minimiert und die Gesamtstromaufnahme des Trennschalters reduziert werden.

Vorteilhafterweise ist der Trennschalter mit einem Zeitgeber versehen, der die Ladungspumpe in Abhängigkeit von der seit der letzten Aktivierung oder Deaktivierung vergangenen Zeit aktiviert oder deaktiviert. Dies ermöglicht eine besonders einfache Realisierung des intermittierenden Betriebs der Ladungspumpe, ohne dass eine schaltungstechnisch aufwändige Überwachung der Gate-Spannung erforderlich ist.

Vorzugsweise ist eine Einschaltdauer der Ladungspumpe dabei zumindest so lange gewählt, dass der Gate-Anschluss des Halbleiterschalters auf einen vorgegebenen Maximalwert aufgeladen wird. Außerdem ist eine Ausschaltdauer der Ladungspumpe vorzugsweise höchstens so lange gewählt, dass der Gate-Anschluss des Halbleiterschalters auf einen vorgegebenen Minimalwert entladen wird. Dadurch wird sichergestellt, dass die Gate-Spannung nicht unter den für eine vollständige Durchsteuerung des Halbleiterschalters erforderlichen Wert abfällt.

Vorteilhafterweise wird die Steuerschaltung die Ladungspumpe in Abhängigkeit von der Höhe der Gate-Spannung des Halbleiterschalters aktivieren und in Abhängigkeit von der seit der letzten Aktivierung vergangenen Zeit deaktivieren. Dadurch kann auf einfache Weise sichergestellt werden, dass die Gate-Spannung nicht unter den für eine vollständige Durchsteuerung des Halbleiterschalters erforderlichen Wert abfällt, und zugleich die Stromaufnahme der Ladungspumpe und somit die Gesamtstromaufnahme des Trennschalters reduziert werden.
Erfindungsgemäß ist der Trennschalter mit einem Temperatursensor zur Überwachung der Temperatur des Halbleiterschalters versehen, wobei die Steuerschaltung die Ladungspumpe in Abhängigkeit von der überwachten Temperatur aktiviert. Die Steuerschaltung aktiviert die Ladungspumpe, wenn eine vorbestimmte Grenztemperatur überschritten wird. Vorzugsweise schaltet darüber hinaus die Steuerschaltung den Halbleiterschalter ein, wenn die vorbestimmte Grenztemperatur überschritten wird. Auf diese Weise kann eine Überhitzung des Trennschalters verhindert werden.
Vorteilhafterweise überwacht die Steuerschaltung zusätzlich den Strom durch den Halbleiterschalter und schaltet den Halbleiterschalter bei Überschreitung der vorbestimmte Grenztemperatur nur dann ein, wenn der überwachte Strom anzeigt, dass der Halbleiterschalter invers betrieben wird. Dadurch kann vermieden werden, dass eine externe Erwärmung der gesamten Baugruppe die thermische Aktivierung des Halbleiterschalters auslöst.
Vorteilhafterweise ist der Trennschalter mit einem Steuersignaleingangsanschluss versehen, wobei die Steuerschaltung den Halbleiterschalter in Abhängigkeit von einem an dem Steuersignaleingangsanschluss anliegenden Steuersignal ein- und ausschaltet. Auf diese Weise ist der Trennschalter universell einsetzbar und kann z.B. das Bordnetz gemäß eines externen Steuersignals in zwei Bereiche trennen.

Vorteilhafterweise ist der Trennschalter mit einem Steuersignalausgangsanschluss versehen, an dem ein Steuersignal ausgegeben wird, wenn die Steuerschaltung die Ladungspumpe oder den Halbleiterschalter in Abhängigkeit von der überwachten Temperatur aktiviert. Mittels des ausgegebenen Steuersignals können beispielsweise weitere, parallel geschaltete Trennschalter angesteuert werden.

Vorteilhafterweise ist der Trennschalter mit einem bidirektionalen Steuersignalanschluss versehen, an dem ein Steuersignal ausgegeben wird, wenn die Steuerschaltung die Ladungspumpe oder den Halbleiterschalter in Abhängigkeit von der überwachten Temperatur aktiviert, wobei die Steuerschaltung den Halbleiterschalter in Abhängigkeit von der überwachten Temperatur und einem an dem bidirektionalen Steuersignalanschluss eingegebenen Steuersignal ein- und ausschaltet. Auf diese Weise kann die Ansteuerung einer Mehrzahl parallel geschalteter Trennschalter mit einer besonders einfachen Schaltungsanordnung erreicht werden.

Vorteilhafterweise ist der Trennschalter mit einer Stromversorgungsschaltung zur Versorgung der Ladungspumpe und der Steuerschaltung mit Strom versehen. Vorzugsweise ist ein Eingang der Stromversorgungsschaltung mit dem Drain-Anschluss des Halbleiterschalters verbunden. Alternativ kann der Eingang der Stromversorgungsschaltung auch mit dem Source-Anschluss des Halbleiterschalters verbunden sein. Der Trennschalter benötigt damit keinen separaten Stromversorgungsanschluss, da er seine Versorgungsspannung direkt aus der zu schaltenden Spannung bezieht. Höchst vorzugsweise ist ein erster Eingang der Stromversorgungsschaltung mit dem Drain-Anschluss und ein zweiter Eingang der Stromversorgungsschaltung mit dem Source-Anschluss des Halbleiterschalters verbunden. In diesem Fall kann der Trennschalter auch dann noch betrieben werden, wenn eine der beiden Seiten bei geöffnetem Trennschalter stromlos wird.

Vorteilhafterweise ist der Trennschalter mit einem Eingangsanschluss und einem Ausgangsanschluss versehen, wobei der Halbleiterschalter den Eingangsanschluss mit den Ausgangsanschluss verbindet. Vorzugsweise ist der Drain-Anschluss des Halbleiterschalters direkt mit dem Eingangsanschluss des Trennschalters und der Source-Anschluss des Halbleiterschalters direkt mit dem Ausgangsanschluss des Trennschalters verbunden.

Vorteilhafterweise ist der Trennschalter mit einem Umschalter versehen, wobei die Steuerschaltung den Gate-Anschluss des Halbleiterschalters über den Umschalter mit der Ladungspumpe verbindet, um den Halbleiterschalter einzuschalten, und den Gate-Anschluss des Halbleiterschalters über den Umschalter mit dem Source-Anschluss des Halbleiterschalters verbindet, um den Halbleiterschalter auszuschalten.

Vorteilhafterweise ist der Halbleiterschalter ein MOSFET. MOSFETs zeichnen sich durch eine leistungslose Ansteuerung aus, wodurch die Leistungsaufnahme des Trennschalters reduziert werden kann.

Vorteilhafterweise sind der Halbleiterschalter, die Ladungspumpe und die Steuerschaltung in einem gemeinsamen Gehäuse integriert. Vorzugsweise sind der Halbleiterschalter, die Ladungspumpe und die Steuerschaltung auf einem Chip monolithisch integriert. Auf diese Weise können die Leckströme, die zur Entladung des Gate-Kondensators des Halbleiterschalters führen, effektiv reduziert werden. Darüber hinaus können dadurch Fertigungs- und Handhabungskosten deutlich reduziert werden.

Alternativ können der Halbleiterschalter einerseits und die Ladungspumpe zusammen mit der Steuerschaltung andererseits auch auf zwei getrennten Chips in getrennten Gehäusen untergebracht sein. Auf diese Weise können unterschiedliche Halbleiterschalter mit einer vorgefertigten Einheit aus Ladungspumpe und Steuerschaltung kombiniert werden. Vorzugsweise kann dabei auch eine Mehrzahl von Ladungspumpen und Steuerschaltungen auf einem der zwei getrennten Chips integriert sein. Somit können mehrere, in jeweils eigenen Gehäusen untergebrachte Halbleiterschalter durch Kombination mit den integrierten Ladungspumpen und Steuerschaltungen in einfacher Weise angesteuert werden.

Die Erfindung wird im folgenden unter Bezugnahme auf die beigefügten Abbildungen beschrieben, in denen:
- Fig. 1: den prinzipiellen Aufbau eines elektronischen AUS-Schalters mit spannungsgesteuerter Aktivierung der Ladungspumpe gemäß einer Ausführungsform der vorliegenden Erfindung zeigt,
- Fig. 2: den Aufbau eines elektronischen Trennschalters mit spannungsgesteuerter Aktivierung der Ladungspumpe gemäß einer ersten Ausführungsform der vorliegenden Erfindung in einer alternativen Anwendung zeigt,
- Fig. 3: eine Schaltungsvariante zur Erkennung eines Stromflusses durch die Body-Diode durch Messung des Spannungsabfalles über einem ShuntWiderstand zeigt,
- Fig. 4: eine Schaltungsvariante zur Erkennung eines Stromflusses durch die Body-Diode durch Messung des Spannungsabfalles über der Body-Diode in Durchlaßrichtung zeigt,
- Fig. 5: den Aufbau eines elektronischen Trennschalters mit zeitgesteuerter Aktivierung der Ladungspumpe gemäß einer zweiten Ausführungsform der vorliegenden Erfindung zeigt,
- Fig. 6: eine Schaltungsvariante mit mehreren parallel geschalteten elektronischen AUS-Schaltern und logisch verknüpften Steuersignalen zeigt,
- Fig. 7: eine Schaltungsvariante mit mehreren parallel geschalteten elektronischen AUS-Schaltern und mittels wired-OR logisch verknüpften Steuersignalen zeigt,
- Fig. 8: den Aufbau eines Kfz-Bordnetzes mit einem Trennschalter gemäß der vorliegenden Erfindung zeigt,
- Fig. 9: den Aufbau eines Kfz-Bordnetzes mit einem Trennschalter gemäß einer Variante der vorliegenden Erfindung zeigt,
- Fig. 10: den Aufbau eines Kfz-Bordnetzes mit einem herkömmlichen Trennschalter zeigt.

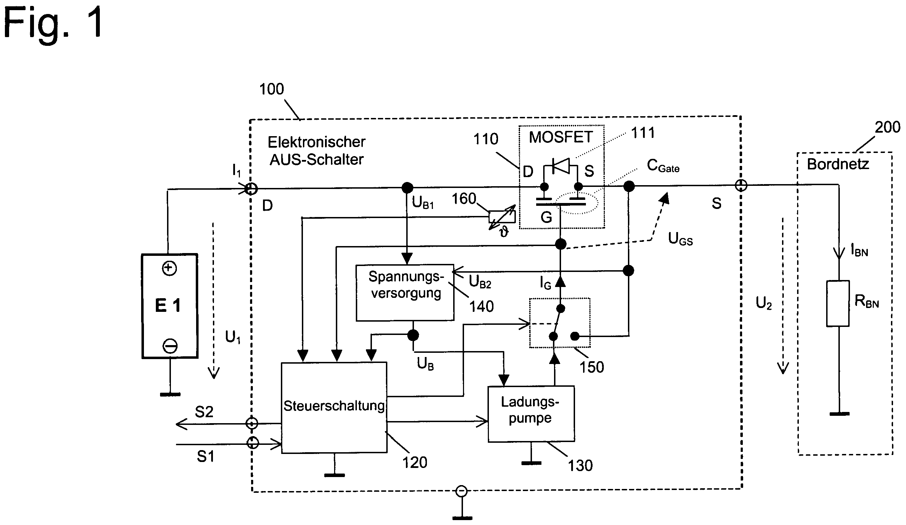

Eine mögliche Anwendung des elektronischen AUS-Schalters 100 wird im folgenden anhand der Fig. 1 beschrieben. Teile eines Kfz-Bordnetzes 200 müssen auch bei abgestelltem Fahrzeug, also bei Zündung AUS, mit Strom versorgt werden, so z.B. die Innenbeleuchtung, Steckdosen, Radio, Alarmanlage oder Schließanlage. Um zu verhindern, dass bei einer zu hohen Dauerstromaufnahme dieser Systeme (z.B. durch einen an die Steckdose angeschlossene Kühlbox) bei abgestelltem Fahrzeug die Batterie E1 unzulässig stark entladen wird, wird die Stromaufnahme all dieser Verbraucher permanent überwacht. Wird ein zu hoher Dauerstrom erkannt, so werden diese Verbraucher abgeschaltet. Hierzu kann z.B. ein MOSFET 110 als elektronischer Ausschalter eingesetzt werden. Im Normalfall ist dieser Schalter immer eingeschaltet, also auch bei Zündung AUS, um die angeschlossenen Verbraucher permanent zu versorgen. Daher ist es sehr wichtig, dass der Eigenstromverbrauch (die Ruhestromaufnahme) dieses Schalter sehr gering ist, vorzugsweise nur wenige µA. In dieser Anwendung wird der MOSFET "normal" betrieben, also Stromfluss von Drain nach Source; ist der MOSFET aus, also nichtleitend, gilt: U2 = 0 V.

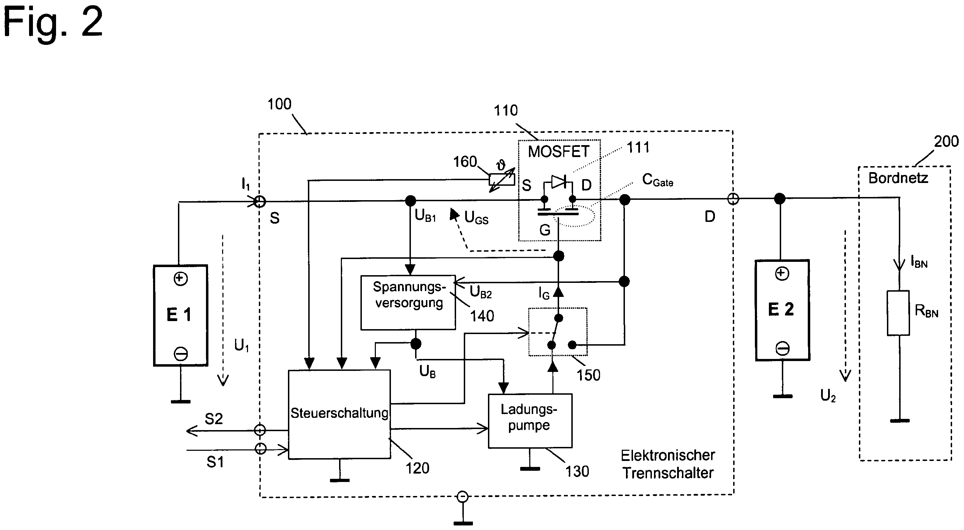

Eine weitere mögliche Anwendung des elektronischen AUS-Schalters 100 besteht in der kurzzeitigen Trennung des Bordnetzes in zwei Bereiche, z.B. beim Starten des Motors, um einen Spannungseinbruch durch den starken Anlasserstrom auf einen Bereich des Bordnetzes zu beschränken. Wie in den Figuren 2 bis 5 gezeigt wird, ist dabei jeder Bereiche mit einem eigenen Energiespeicher E1 bzw. E2 versehen. In der Anwendung Trennschalter wird der MOSFET 110, wenn er stromdurchflossen ist, invers betrieben; d.h. der Strom fließt von Source nach Drain. Der MOSFET ist dauernd eingeschaltet, also leitend, um die interne Body-Diode zu überbrücken. Nur in der Funktion "Trennen", wenn also z.B. bei einem Einbruch der Spannung U1 auf der Seite des Energiespeichers E1 das Bordnetz nur aus dem Energiespeicher E2 versorgt werden soll, wird der MOSFET gesperrt. Ein Stromfluss durch dessen Body-Diode ist dann nicht möglich, weil während des Spannungseinbruches gilt: U1 < U2.

Da auch in dieser Anwendung der Trennschalter immer eingeschaltet ist, ist es sehr wichtig, dass der Eigenstromverbrauch (die Ruhestromaufnahme) dieses Schalter sehr gering ist, vorzugsweise nur wenige µA.

Unter Bezugnahme auf Figur 1 wird im folgenden das Prinzip des erfindungsgemäßen elektronischen AUS-Schalters erläutert.

In dem mit dem Bezugszeichen 100 bezeichneten elektronischen AUS-Schalter werden vorzugsweise MOSFETs als Halbleiterschalter 110 eingesetzt. MOSFETs sind Feldeffekttransistoren, die im Gegensatz zu den Bipolartransistoren leistungslos angesteuert werden. Auch stehen mit den so genannten n-Kanal-MOSFETs Halbleiterschalter mit sehr niedrigen Einschaltwiderständen (der so genannte R_{DSon}, Werte im Bereich von wenigen mΩ) zur Verfügung, mit denen Ströme von mehreren 100 A geschaltet werden können.

Ein Feldeffekttransistor wird eingeschaltet, indem an die Gate- und Source-Anschlüsse des Transistors eine Spannung von typisch 10 V bis 15 V angelegt wird. Dadurch wird die Drain-Source-Strecke niederohmig, und ein Stromfluss wird möglich. In den Gate-Anschluss fließt nur kurzzeitig ein Strom, bis die Gate-Kapazität aufgeladen ist: Die Ansteuerung eines Feldeffekttransistors erfolgt spannungsgesteuert. Im Gegensatz hierzu erfolgt die Ansteuerung eines Bipolartransistors stromgesteuert. Durch den in den Basisanschluss (Steuereingang des Bipolartransistors) hineinfließenden Basisstrom wird der durch die Kollektor-Emitter-Strecke fließende Laststrom gesteuert. D.h. solange der Bipolartransistor sich im Zustand EIN befindet, muss der Basistrom, der nur um den Faktor 10 bis 100 kleiner ist als der Laststrom, von einer Ansteuerschaltung zur Verfügung gestellt werden.

Die meisten Anwendungen erfordern so genannte High-Side-Schalter. Die Verbraucher sind mit einem Versorgungsspannungsanschluss fest mit Masse verbunden.

Der High-Side-Schalter schaltet die in der Regel positive Versorgungsspannung an die Verbraucher durch. Ist der High-Side-Schalter in der Funktion als AUS-Schalter mit Hilfe eines MOSFETs realisiert, so ist der Drain-Anschluss des MOSFETs mit der Versorgungsspannung und der Source-Anschluss mit dem Verbraucher verbunden. Im durchgesteuerten Zustand ist der Spannungsabfall über der Drain-Source-Strecke des MOSFETs sehr gering, sodass die Spannung am Source-Anschluss nahezu gleich der Spannung am Drain-Anschluss und damit gleich der Versorgungsspannung ist. Das bedeutet für die Ansteuerung eines n-Kanal-MOSFETs, dass eine Gate-Spannung benötigt wird, die um typisch 12 V bis 18 V höher ist als die Versorgungsspannung des Fahrzeugbordnetzes. Dies macht eine so genannte Ladungspumpe 130 erforderlich, die mit Hilfe z.B. einer Switched-Capacitor-Schaltung die benötigte erhöhte Gate-Spannung erzeugt.

Über ein externes Steuersignal S1 kann der MOSFET 110 ausgeschaltet werden. Hierzu wird der Gate-Anschluss G des MOSFETs mittels eines Umschalters 150 von der Ladungspumpe 130 getrennt und mit dem Source-Anschluss S verbunden, um die Gate-Kapazität C_{Gate} zu entladen.

Der für die Funktion der Ladungspumpe 130 erforderliche Betriebsstrom muss dauernd zur Verfügung gestellt werden und belastet daher dauernd das Fahrzeugbordnetz. Da der elektronische AUS-Schalter auch bei abgestelltem Fahrzeug ("Zündung AUS") aktiv ist, besteht die Forderung nach einer sehr geringen Stromaufnahme im Bereich von wenigen 10 µA, damit bei abgestelltem Fahrzeug die Batterie nicht unnötig entladen wird. Werden mehrere (beispielsweise 10) elektronische AUS-Schalter parallel geschaltet, um die Stromtragfähigkeit zu erhöhen, so darf die Stromaufnahme eines einzelnen elektronischen AUS-Schalters nur einige µA betragen. Um diese Anforderung zu erfüllen, sind zusätzliche Maßnahmen erforderlich, die im folgenden beschrieben werden.

Im Idealfall muss die Ladungspumpe 130 nur den Strom liefern, der erforderlich ist, um die Gate-Kapazität C_{Gate} des MOSFETs 110 aufzuladen. Danach fließt kein Strom mehr in das Gate des MOSFETs. Im Realen kommt es durch parasitäre Widerstände im MOSFET selbst und in der restliche Schaltung zu Leckströmen, die die Gate-Kapazität entladen. Diese Leckströme steigen mit zunehmender Temperatur stark an und müssen von der Ladungspumpe ständig zur Verfügung gestellt werden. Es zeigt sich, vor allem wenn die Ladungspumpe und der MOSFET zusammen in einem Gehäuse untergebracht werden, dass die Leckströme selbst bei hohen Temperaturen so gering sind, dass sich eine Entladung der Gate-Kapazität und damit ein Absinken der Gate-Source-Spannung erst nach einigen 10 Sekunden bemerkbar macht. Erfindungsgemäß wird die Ladungspumpe daher nicht dauernd sondern intermittierend betrieben. Damit lässt sich die mittlere Stromaufnahme der Ladungspumpe um den Faktor 10 bis 100 reduzieren.

Intermittierender Betrieb der Ladungspumpe bedeutet, dass die Ladungspumpe nur für eine kurze Zeit T_{Ein} aktiv ist und dann für eine längere Zeit T_{Aus} nicht arbeitet. Die Einschaltzeit ist im Wesentlichen durch die Zeit bestimmt, die die Ladungspumpe benötigt, bis die erforderliche Gate-Spannung erreicht ist und liegt abhängig von der Art der Realisierung der Ladungspumpe zwischen einigen 100 µs und 10 ms. Die Ausschaltzeit T_{Aus} kann um den Faktor 10 bis 1.000 länger sein als die Zeit T_{Ein} und liegt zwischen einigen ms und 10 s. Die Steuerung des intermittierenden Betriebs erfolgt durch eine Steuerschaltung 120, die die Ladungspumpe abwechselnd ein- und ausschaltet. Die wechselweise Aktivierung und Deaktivierung der Ladungspumpe kann beispielsweise über eine Unterbrechung der Stromversorgung der Ladungspumpe oder des die Ladungspumpe steuernden Oszillators erfolgen.

Die Versorgungsspannung U_{B} für die Steuerschaltung 120 und für die Ladungspumpe 130 kann entweder vom Anschluss D (Spannung U_{B1}) oder vom Anschluss S (Spannung U_{B2}) des elektronischen AUS-Schalters 100 abgegriffen werden. Weiterhin kann die Versorgungsspannung U_{B} auch mit Hilfe eines weiteren Schaltungsteiles 140 ("Spannungsversorgung") sowohl vom Anschluss D (Spannung U_{B1}) als auch vom Anschluss S (Spannung U_{B2}) erfolgen.

Sowohl die Aktivierung als auch die Deaktivierung der Ladungspumpe 130 kann spannungs- oder zeitgesteuert erfolgen. Optional kann zusätzlich eine temperaturgesteuerte Aktivierung erfolgen. Hierdurch kann der MOSFET in den beiden folgenden Fehlerfällen vor einer thermischen Überlastung und Zerstörung geschützt werden.

Sinkt die Gate-Spannung, während die Ladungspumpe deaktiviert ist, zu stark ab, so steigt der R_{DSon} des MOSFETs und damit die Verlustleistung an. Es kommt zu einer unzulässigen Erwärmung des MOSFETs. Die Steuerschaltung 120 überwacht die Temperatur des MOSETs 110 mittels eines Temperatursensors 160. Bei Überschreitung einer vorgegebenen Grenztemperatur wird die Steuerschaltung unabhängig von der spannungs- oder zeitgesteuerten Aktivierung die Ladungspumpe einschalten, so dass die Gate-Spannung wieder ansteigt und der MOSFET wieder voll durchgesteuert wird.

Wird der MOSFET auch invers betrieben, d.h. wenn der Strom nicht nur von Drain nach Source sondern auch umgekehrt von Source nach Drain fließen kann, ist auch bei nicht durchgesteuertem MOSFET eine Stromfluss durch die Body-Diode 111 des MOSFETs möglich. Durch den wesentlich höheren Spannungsabfall - vorallem bei hohen Strömen und niedrigen Temperaturen - über der Body-Diode (ca. 1 V statt 10 mV bis 100 mV) kommt es auch in diesem Fall zu einer unzulässigen Erwärmung des MOSFETs. Die temperaturgesteuerte Aktivierung schaltet dann unabhängig von der spannungs- oder zeitgesteuert Aktivierung die Ladungspumpe ein. Vorzugsweise wird die Steuerschaltung in diesem Falle zusätzlich den MOSFET einschalten, wenn dieser ausgeschaltet ist (Steuersignal S1 = AUS).

Optional kann der elektronische AUS-Schalter auch ein Signal S2 ausgeben, das parallel geschaltete weitere elektronische AUS-Schalter einschaltet, wenn diese ausgeschaltet sind. Das Signal S2 wird ausgegeben bzw. ist aktiv, solange die temperaturgesteuerte Aktivierung die Ladungspumpe und den MOSFET eingeschaltet hat, wenn dieser ausgeschaltet ist (Steuersignal S1 = AUS). Dies ist z.B. dann sinnvoll, wenn mehrere parallel geschaltete elektronische AUS-Schalter sich im Zustand AUS befinden und ein erster von diesen durch die temperaturgesteuerte Aktivierung einschaltet. Hierdurch wird verhindert, dass dieser erste elektronische AUS-Schalter überlastet wird, weil nur er einschaltet. Das Signal S2 signalisiert also einen Fehlerzustand und zeigt insbesondere an, dass der MOSFET durch einen Fehler und nicht durch das Ansteuersignal S1 eingeschaltet worden ist (z.B. S2=H für thermische Aktivierung EIN und S2=L für alle anderen Fälle). Wird die thermische Aktivierung zurückgenommen, weil sich der überhitzte MOSFET abgekühlt hat, werden alle elektronischen AUS-Schalter wieder ausgeschaltet.

Optional kann das Signal S2 auf dem gleichen Signalpfad wie das Signal S1 als bidirektionales Signal S12 ausgegeben werden, so dass nur ein Signalanschluss und nur eine Signalleitung benötigt werden.

Figur 2 zeigt den Aufbau eines elektronischen Trennschalters 100 mit spannungsgesteuerter Aktivierung der Ladungspumpe gemäß einer ersten Ausführungsform der vorliegenden Erfindung.

Als Schaltelement 110 wird vorzugsweise ein n-Kanal MOSFET eingesetzt, der den Eingangsanschluss S mit dem Ausgangsanschluss D des elektronischen AUS-Schalters 100 verbindet. Die für die Ansteuerung des MOSFETs erforderliche Gate-Spannung U_{GS} wird von der Ladungspumpe 130 erzeugt.

Die Ladungspumpe kann z.B. auf einer Switched-Capacitor-Schaltung beruhen, bei der zwei Kondensatoren, gesteuert durch einen Oszillator, als Parallelschaltung bzw. als Serienschaltung wechselweise zwischen dem Eingang bzw. dem Ausgang der Ladungspumpe hin und her geschaltet werden. Auf diese Weise kann die an der Ladungspumpe anliegende Eingangsspannung in etwa verdoppelt werden. Durch eine Kaskadierung derartiger Ladungspumpen oder durch eine Schaltungsanordnung mit drei oder mehr Kondensatoren können auch höhere Übersetzungsverhältnisse erzielt werden.

Die vorliegende Erfindung ist aber nicht auf eine bestimmte Realisierung der Ladungspumpe beschränkt, da die gleichen Vorteile auch mit anderen Gleichspannungswandlern erzielt werden können, wie. z.B. mittels einer durch einen Oszillator angesteuerten Spule oder eines Transformators mit nachgeschaltetem Gleichrichter.

Die Steuerschaltung 120 steuert sowohl den MOSFET in Abhängigkeit von dem externen Steuersignal S1, als auch den intermittierenden Betrieb der Ladungspumpe 130. Bei der spannungsgesteuerten Aktivierung der Ladungspumpe überwacht die Steuerschaltung 120 dazu die Spannung U_{GS} zwischen Gate und Source des MOSFETs 110. Sinkt diese unter einen vorgegebenen Wert ab, so wird die Ladungspumpe 130 solange aktiviert, bis die Spannung U_{GS} wieder den Ausgangswert erreicht hat.

Die Steuerschaltung kann dazu die Spannung U_{GS} beispielsweise über einen Spannungsteiler und einen Komparator mit einer Referenzspannung vergleichen und die Ladungspumpe aktivieren, sobald eine Unterschreitung detektiert wird. Danach kann die Ladungspumpe wieder deaktiviert werden, wenn die durch den Spannungsteiler geteilte Spannung U_{GS} den Wert der Referenzspannung überschreitet.

Um die Frequenz der Aktivierungs- und Deaktivierungsvorgänge zu reduzieren und insbesondere die Phase, in der die Ladungspumpe deaktiviert ist, zu verlängern, erfolgt die Aktivierung und die Deaktivierung der Ladungspumpe vorzugsweise mit einer gewissen Hysterese. Die Steuerschaltung würde dazu unterschiedliche Schaltschwellen für die Aktivierung und die Deaktivierung implementieren, so dass die Ladungspumpe erst wieder deaktiviert wird, wenn eine Spannung erreicht ist, die um einige Volt größer ist als die Spannung, bei der die Ladungspumpe aktiviert wurde. Bei einem 12 V Bordnetz liegt die Deaktivierungsschwelle vorzugsweise zwischen 12 V und 18 V und Aktivierungsschwelle vorzugsweise 1 V bis 6 V unterhalb der Deaktivierungsschwelle.

Normalerweise ist der Gate-Anschluss des MOSFET über den Umschalter 150 mit dem Ausgang der Ladungspumpe 130 verbunden, d.h. der elektronische AUS-Schalter ist geschlossen. In Abhängigkeit von dem externen Steuersignal S1 verbindet die Steuerschaltung 120 den Gate-Anschluss des MOSFETs über den Umschalter 150 jedoch mit dem Source-Anschluss, um den Gate-Kondensator zu entladen und somit den MOSFET zu sperren. Optional kann die Steuerschaltung 120 auch ein Steuersignal S2 ausgeben, das den Schaltzustand des elektronischen AUS-Schalters angibt.

Zusätzlich zur spannungsgesteuerten Aktivierung der Ladungspumpe kann die Steuerschaltung 120 mit Hilfe des Sensors 160 die Temperatur des MOSFETs überwachen und, wie oben beschrieben, die Ladungspumpe und ggf. auch den MOSFET einschalten, sobald eine vorgegebene Grenztemperatur überschritten wird. Die Grenztemperatur wird so gewählt, dass eine Beschädigung des MOSFET oder seiner Umgebung durch eine Überhitzung ausgeschlossen ist, also etwa im Bereich von 100 °C bis 130 °C, vorzugsweise bei 115 °C mit einer Hysterese von 5 K bis 10 K.

Die thermische Aktivierung der Ladungspumpe kann in beiden Betriebszuständen EIN bzw. AUS des elektronischen AUS-Schalters erfolgen.

Im Betriebszustand 1 befindet sich der elektronische AUS-Schalter im Zustand EIN und die Ladungspumpe arbeitet im intermittierenden Betrieb, um die Ruhestromaufnahme zu reduzieren. Sinkt nun während der AUS-Phase der Ladungspumpe im intermittierenden Betrieb die Gate-Spannung U_{GS} des MOSFETs soweit ab, dass sich dessen Einschaltwiderstand R_{DSon} merklich erhöht, so erhöht sich die im MOSFET umgesetzte Verlustleistung und die Temperatur des MOSFETs bzw. Trennschalters steigt. Überschreitet diese Temperatur die vorgegebene Grenztemperatur, so wird die Ladungspumpe eingeschaltet. Infolgedessen steigt die Gate-Spannung wieder an und der Einschaltwiderstand R_{DSon} geht wieder auf seinen Minimalwert zurück.

Im Betriebszustand 2 befindet sich der elektronische AUS-Schalter im Zustand AUS und die Ladungspumpe arbeitet nicht. Ist in Abhängigkeit von der jeweiligen Applikation die Spannung am Source-Anschluss des MOSFETs höher als am Drain-Anschluss, kommt es zu einem Stromfluss durch die Body-Diode des MOSFETs, also Stromrichtung vom Source- zum Drain-Anschluss des MOSFETs. Der MOSFET wird invers betrieben. Überschreitet der dabei fließende Strom einen bestimmten Wert, so erhöht sich wegen des hohen Spannungsabfalls von ca. 1 V über der Body-Diode die im MOSFET umgesetzte Verlustleistung und die Temperatur des MOSFETs bzw. Trennschalters steigt. Überschreitet diese Temperatur die vorgegebene Grenztemperatur, so werden die Ladungspumpe und der MOSFET eingeschaltet. Damit sinkt der Spannungsabfall über dem MOSFET, und die Verlustleistung und damit die Eigenerwärmung gehen zurück.

Optional erfolgt die thermische Aktivierung nur bei einem inversen Stromfluss durch den MOSFET, da nur in diesem Fall die Übertemperatur des MOSFETs durch die Eigenerwärmung, ausgelöst durch den Stromfluss durch den MOSFET und den Spannungsabfall über der Body-Diode, verursacht wird. Wird die Übertemperatur durch eine Erwärmung der gesamten Baugruppe durch eine externe Wärmequelle ausgelöst, so erfolgt keine thermische Aktivierung der Ladungspumpe und der MOSFET wird nicht eingeschaltet.

Das Erkennen eines inversen Stromflusses durch den MOSFET kann auf zwei Arten erfolgen, und zwar mittels einer echten Strommessung mit Hilfe eines Mess-Shunts oder durch Erkennen eines Spannungsabfalles über der Source-Drain-Strecke: U_{SD} > 0.

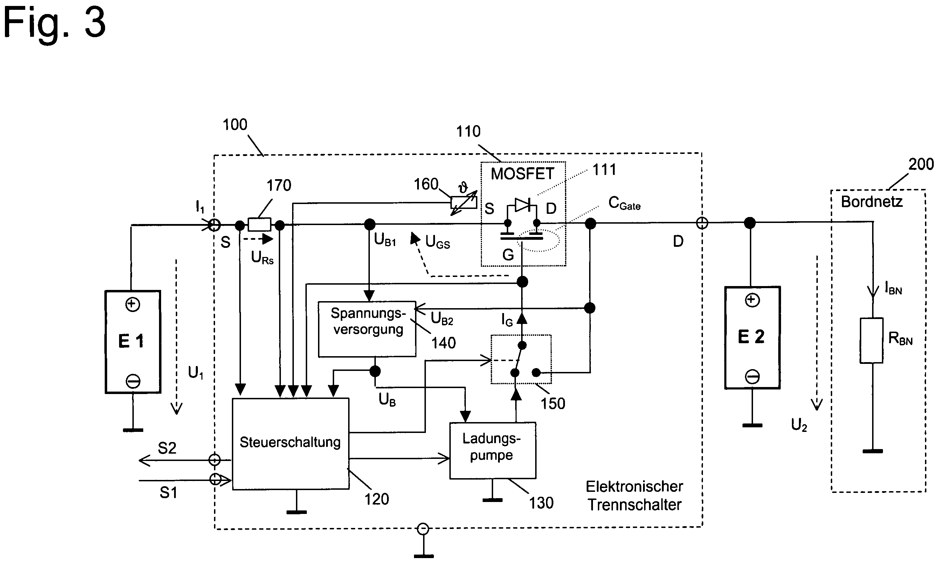

Figur 3 zeigt eine Schaltungsvariante zur Erkennung eines Stromflusses durch die Body-Diode durch Messung des Spannungsabfalles über einem Shunt-Widerstand. Der in Fig. 3 gezeigte Aufbau entspricht im Wesentlichen dem der Fig. 2, wobei jedoch zusätzlich ein Shunt-Widerstand 170 zur Messung des Stroms durch die Body-Diode vorgesehen ist.

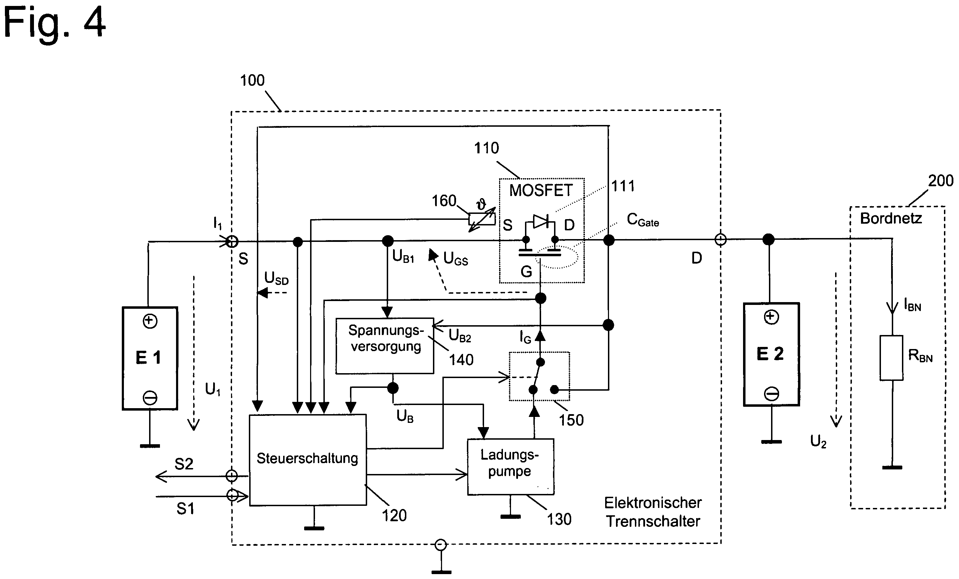

Figur 4 zeigt eine Schaltungsvariante zur Erkennung eines Stromflusses durch die Body-Diode durch Messung des Spannungsabfalles über der Body-Diode in Durchlaßrichtung. Der in Fig. 4 gezeigte Aufbau entspricht im Wesentlichen dem der Fig. 2, wobei die Steuerschaltung 120 jedoch mit zusätzlichen Eingängen zur Messung des Spannungsabfalles über der Body-Diode versehen ist.

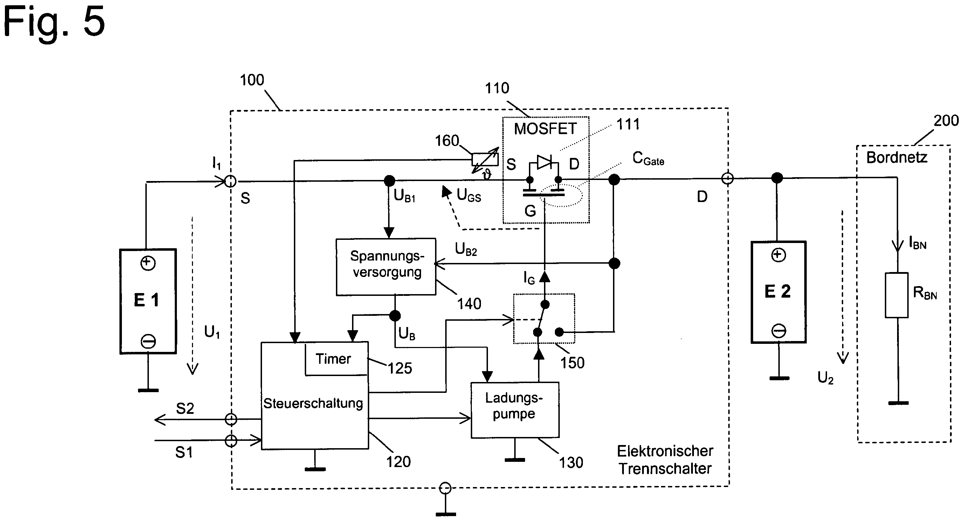

Figur 5 zeigt den Aufbau eines elektronischen Trennschalters mit zeitgesteuerter Aktivierung der Ladungspumpe gemäß einer zweiten Ausführungsform der vorliegenden Erfindung. Diese Ausführungsform gleicht der in Fig. 2 gezeigten Ausführungsform, wobei lediglich die Steuerschaltung nicht die Gate-Spannung überwacht sondern stattdessen mit einem Zeitgeber 125 für eine zeitgesteuerte Aktivierung der Ladungspumpe versehen ist.

Bei der zeitgesteuerten Aktivierung der Ladungspumpe wird über die Zeitgeberschaltung 125 periodisch die Ladungspumpe 130 für eine bestimmt Zeit aktiviert. Die Ladungspumpe wird dabei mit einer Wiederholungszeit T_{W} von vorzugsweise 1s, die aber auch im Bereich von einigen ms bis 10s liegen kann, für eine Einschaltzeit T_{Ein} von einigen 100 µs bis 10 ms eingeschaltet. Selbstverständlich gilt T_{W} = T_{Ein}+T_{Aus}. Die genauen Zahlenwerte für T_{W} und T_{Ein}, bzw. für T_{Aus} und T_{Ein} können durch Versuche ermittelt werden, um sicherzustellen, dass die Gate-Spannung bei eingeschaltetem MOSFET nicht unter den für die vollständige Durchschaltung erforderlichen Mindestwert abfällt.

Die in den Figuren 2 bis 5 gezeigten Ausführungsformen mit spannungs- bzw. zeitgesteuerter Aktivierung und Deaktivierung können vorteilhafterweise auch kombiniert werden, wobei vorzugsweise die Aktivierung der Ladungspumpe spannungsgesteuert und die Deaktivierung zeitgesteuert erfolgen kann. Die Steuerschaltung überwacht dazu kontinuierlich die Gate-Spannung U_{GS} und aktiviert die Ladungspumpe sobald eine vorgegebene Schwelle unterschritten wird. Die Aktivierung erfolgt dabei für eine vorgegebene Zeitdauer von beispielsweise einigen 100 µs bis 10 ms. Diese Zeitdauer ist so gewählt, dass davon ausgegangen werden kann, dass die erforderliche Mindestspannung in dieser Zeit sicher erreicht wird. Nachdem die vorgegebene Zeitdauer verstrichen ist, wird die Ladungspumpe durch die Steuerschaltung wieder deaktiviert. Die Steuerschaltung kann dazu z.B. mit einem Komparator zur Überwachung der Gate-Spannung und einem nachgeschalteten Monoflop zur Ansteuerung der Ladungspumpe versehen sein.

Außerdem kann die in den Figuren 3 und 4 illustrierte Überwachung des Stromflusses durch die Body-Diode selbstverständlich auch mit der zeitgesteuerten Aktivierung oder Deaktivierung der Ladungspumpe kombiniert werden. Damit kann auch in der zweiten Ausführungsform die thermische Aktivierung so eingerichtet werden, dass sie nur bei einem inversen Stromfluss durch den MOSFET erfolgt.

Die in den Figuren 2 bis 5 gezeigte externe Beschaltung des Trennschalters 100 mit einem ersten Energiespeicher E1, einem zweiten Energiespeicher E2 und dem Bordnetz 200 ist lediglich illustrativ und zeigt eine beispielhafte Einsatzmöglichkeit des Trennschalters.

Die Realisierung der Schaltungsteile Steuerschaltung, Ladungspumpe und Umschalter zusammen mit dem MOSFET kann auf verschiedene Arten erfolgen, z.B. als diskret aufgebaute Schaltung, als integrierte Lösung mit zwei Halbleiterchips in einem oder in mehreren Gehäusen, oder als in einem Gehäuse integrierte monolithische Lösung mit einem Halbleiterchip.

Bei einer Realisierung als diskret aufgebaute Schaltung, z.B. auf einer Leiterplatte, sind Maßnahmen zu ergreifen, um die empfindlichen, d.h. sehr hochohmigen Schaltungsteile wie z.B. Messung der Spannung U_{GS}, Umschalter, Ausgangsstufe der Ladungspumpe und die Verbindung zum Gate-Anschluss des MOSFETs, durch geeignete Maßnahmen wie Lackieren oder Vergießen gegen das Entstehen von parasitären Widerständen zu schützen. Parasitäre Widerständen entstehen z.B. aus Ablagerungen bzw. Verschmutzungen auf der Leiterplatte zusammen mit Feuchtigkeit.

Bei einer Realisierung als integrierte Lösung mit zwei Halbleiterchips in zwei Gehäusen kann der erste Halbleiterchip den MOSFET darstellen und der zweite Halbleiterchip die Steuerschaltung, die Ladungspumpe und den Umschalter enthalten. Auch in dieser Realisierung müssen die elektrischen Verbindungen zwischen den zwei Halbleiterchips in zwei Gehäusen durch geeignete Maßnahmen wie Lackieren oder Vergießen gegen das Entstehen von parasitären Widerständen geschützt werden.

Bei einer Realisierung als integrierte Lösung mit zwei Halbleiterchips in einem Gehäuse kann ebenfalls der erste Halbleiterchip den MOSFET darstellen und der zweite Halbleiterchip die Steuerschaltung, die Ladungspumpe und den Umschalter enthalten.

Bei einer Realisierung als in ein Gehäuse integrierte monolithische Lösung enthält der Halbleiterchip den MOSFET, die Steuerschaltung, die Ladungspumpe und den Umschalter.

Besonders vorteilhaft sind die Realisierungen mit nur einem Gehäuse, da diese durch das Vergießen aller Schaltungsteile in dem gemeinsamen Gehäuse unempfindlich gegen das Entstehen von parasitären Widerständen sind.

Um die Stromtragfähigkeit eines elektronischen AUS-Schalters zu erhöhen, können mehrere der erfindungsgemäßen elektronischen AUS-Schalter parallel geschaltet werden. Vorteilhafterweise werden die Steuersignale S1 und S2 dabei wie nachfolgend beschrieben logisch miteinander verknüpft.

Das Ausgangssignal S2 des Elektronischen AUS-Schalters bzw. das bidirektionale Signal S12 als Ausgangssignal dient dazu, bei der Parallelschaltung von mehreren elektronischen AUS-Schaltern alle AUS-Schalter zu aktivieren, wenn im Invers-Betrieb einer der elektronischen AUS-Schalter bei Übertemperatur durch seine interne thermische Aktivierung eingeschaltet worden ist. Die Anordnung aus mehreren parallelgeschalteten elektronischen AUS-Schaltern wird also im Betriebszustand 2 betrieben. Das Ausgangssignal S2 wird nur dann ausgegeben, wenn der Elektronische AUS-Schalter inaktiv, also ausgeschaltet ist.

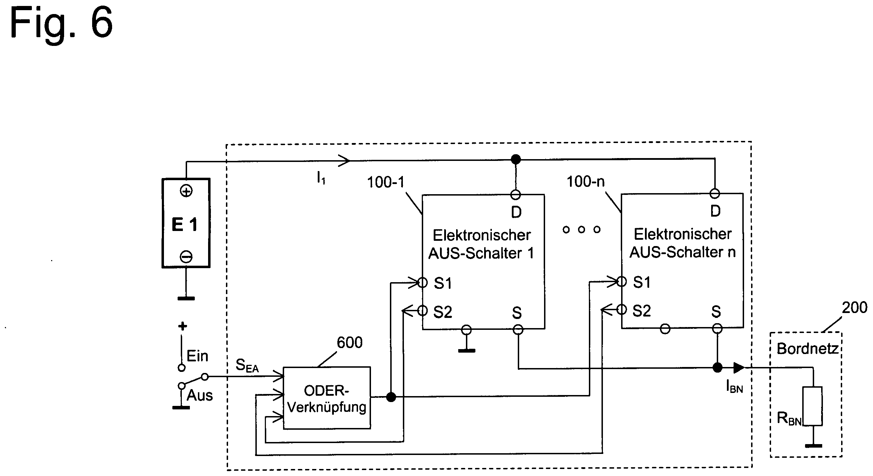

Figur 6 zeigt eine Schaltungsvariante mit mehreren parallel geschalteten elektronischen AUS-Schaltern (100-1, ..., 100-n), wobei die Steuersignale S1 und S2 mit einem ODER-Gatter 600 logisch verknüpft sind.

Das von Extern kommende Signal S_{EA} zum Ein- und Ausschalten der elektronischen AUS-Schalter ist mit allen Ausgangssignalen S2 ODER-verknüpft. Die parallelgeschalteten elektronischen AUS-Schalter können also sowohl durch das Signal S_{EA} als auch durch das Signal S2 eines elektronischen AUS-Schalters, der im Betriebszustand 2 thermisch aktiviert worden ist, eingeschaltet werden. Ist die Parallelschaltung aus mehreren elektronischen AUS-Schaltern durch das Steuersignal S2 eines der Elektronischen AUS-Schalter eingeschaltet worden, so werden diese wieder ausgeschaltet, wenn durch Abkühlung die thermische Aktivierung des betroffenen elektronischen AUS-Schalters wieder zurückgenommen worden ist.

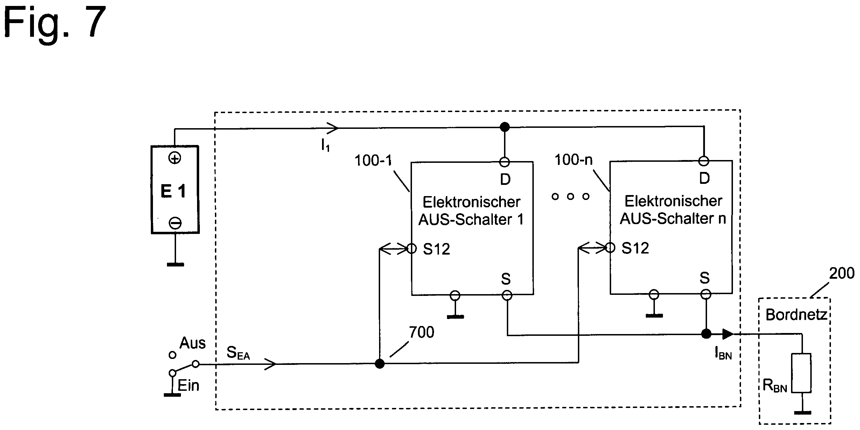

Fig. 7 zeigt eine Schaltungsvariante mit mehreren parallel geschalteten elektronischen AUS-Schaltern, wobei die Steuersignale mittels wired-OR logisch verknüpft sind.

Das von Extern kommende Signal S_{EA} zum Ein- und Ausschalten der Elektronischen AUS-Schalter ist mit allen Steuersignalen S12 durch eine sogenannte "Wired-OR-Verknüpfung" (700) ODER-verknüpft. Das Signal S_{EA} hat hierzu z.B. die beiden elektrischen Zustände offen (hochohmig) für die Funktion AUS, bzw. niederohmig mit der negativen oder positiven Versorgungsspannung verbunden für die Funktion EIN.

Die parallelgeschalteten elektronischen AUS-Schalter können also sowohl durch das Signal SEA als auch durch das Signal S12 eines elektronischen AUS-Schalters, der im Betriebszustand 2 thermisch aktiviert worden ist, eingeschaltet werden. Ist die Parallelschaltung aus mehreren elektronischen AUS-Schaltern durch das Steuersignal S12 eines der elektronischen AUS-Schalter eingeschaltet worden, so werden diese wieder ausgeschaltet, wenn durch Abkühlung die thermische Aktivierung des betroffenen elektronischen AUS-Schalters wieder zurückgenommen worden ist.

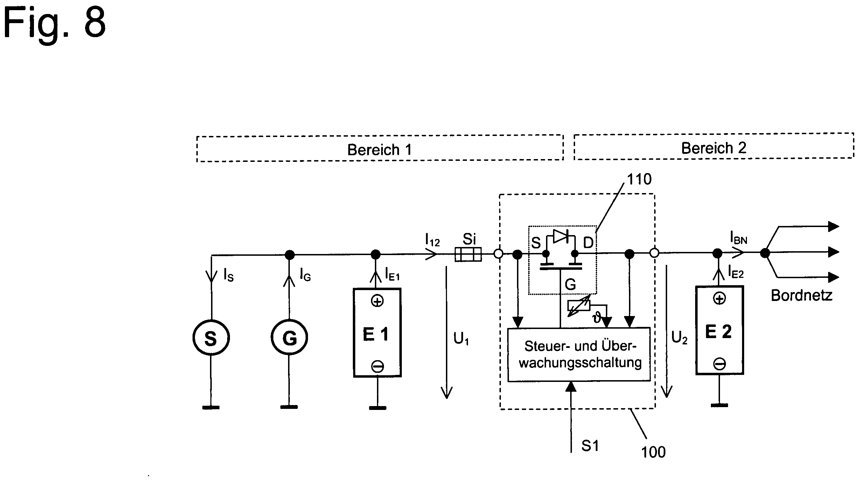

Figur 8 zeigt den Aufbau eines beispielhaften Kfz-Bordnetzes, das mit einem Trennschalter 100 gemäß der vorliegenden Erfindung in zwei Bereiche aufgeteilt wird. Über ein Ansteuersignal S1 wird der Trennschalter geöffnet bzw. geschlossen. Bei laufendem Verbrennungsmotor wird die im Fahrzeug benötigte elektrische Leistung durch den Generator G erzeugt. Der Trennschalter ist normalerweise geschlossen, d.h. die Bereiche 1 und 2 sind elektrisch miteinander verbunden. Der vom Generator erzeugte Strom I_{G} lädt die beiden Energiespeicher E1 und E2 und versorgt das Bordnetz. Bei stehendem Verbrennungsmotor wird vor Einleitung des Startvorgangs der Trennschalter geöffnet, d.h. die Bereiche 1 und 2 werden elektrisch voneinander getrennt. Der Energiespeicher E1 liefert dann den zum Antreiben des Starters S benötigten Strom I_{S}, ohne den Bereich 2 zu beeinflussen.

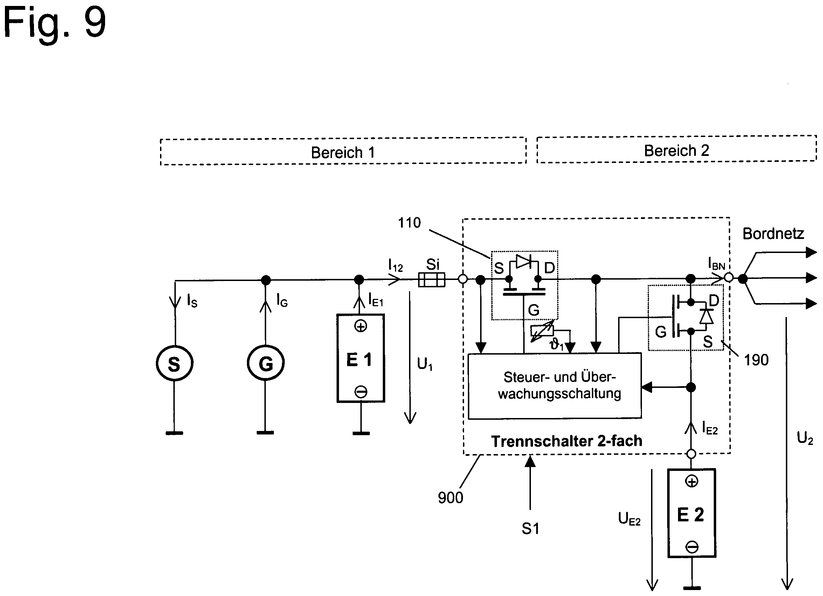

Figur 9 zeigt den Aufbau eines weiteren beispielhaften Kfz-Bordnetzes, das mit einem Trennschalter 900 gemäß einer Variante der vorliegenden Erfindung in zwei Bereiche aufgeteilt wird. Der in Figur 9 gezeigte Aufbau gleicht dem aus Fig. 8, wobei jedoch ein zweiter MOSFET 190 zwischen der Energiequelle E2 und dem Bordnetz vorgesehen ist, um die Energiequelle E2 komplett vom Bordnetz und der Energiequelle E1 zu trennen, wenn das Bordnetz aus der Energiequelle E1 versorgt wird. Bei dieser Anordnung sorgt die Steuerschaltung zusätzlich für das richtige Timing beim Einschalten des einen Schalters und dem Ausschalten des anderen Schalters.

In Fig. 9 ist der Drain-Anschluss des zweiten MOSFETs 190 mit dem Bordnetz verbunden. Der MOSFET 190 wird daher invers betrieben, wenn das Bordnetz aus der Energiequelle E1 versorgt wird. Es ist jedoch stattdessen auch möglich, den Source-Anschluss des MOSFETs 190 mit dem Bordnetz zu verbinden, so dass der MOSFET 190 normal betrieben wird, wenn das Bordnetz aus der Energiequelle E1 versorgt wird.

Die vorliegende Erfindung betrifft also einen elektronischen Trennschalter für Kfz-Bordnetze, der sich durch eine geringe Leistungsaufnahme der Ansteuerung im eingeschalteten Zustand auszeichnet. Erfindungsgemäß wird dazu als Schaltelement ein MOSFET verwendet, wobei die für die Erzeugung der Gate-Spannung erforderliche Ladungspumpe intermittierend betrieben wird. Die Steuerung des intermittierenden Betriebs der Ladungspumpe erfolgt über eine Steuerschaltung, die die Ladungspumpe wechselweise aktiviert und deaktiviert. Die Aktivierung der Ladungspumpe erfolgt spannungsgesteuert, zeitgesteuert, und/oder temperaturgesteuert.

## Patentansprüche

1. Trennschalter für ein Kfz-Bordnetz mit
einem Halbleiterschalter (110) und
einer Ladungspumpe (130) zur Erzeugung einer für die Ansteuerung des Halbleiterschalters erforderlichen Gleichspannung, und
einer Steuerschaltung (120) zur Steuerung eines intermittierenden Betriebs der Ladungspumpe (130) durch wechselweises Aktivieren und Deaktivieren der Ladungspumpe (130),
**gekennzeichnet durch**
einen Temperatursensor (160) zur Überwachung der Temperatur des Halbleiterschalters (110), wobei die Steuerschaltung (120) dazu eingerichtet ist, die Ladungspumpe (130) in Abhängigkeit von der überwachten Temperatur zu aktivieren, wobei die Ladungspumpe aktiviert wird wenn eine vorbestimmte Grenztemperatur überschritten wird.

2. Trennschalter nach Anspruch 1, wobei die Steuerschaltung (120) die Ladungspumpe (130) aktiviert, wenn eine vorbestimmte Grenztemperatur überschritten wird.

3. Trennschalter nach Anspruch 2, wobei die Steuerschaltung (120) den Halbleiterschalter (110) einschaltet, wenn die vorbestimmte Grenztemperatur überschritten wird.

4. Trennschalter nach Anspruch 3, wobei die Steuerschaltung (120) zusätzlich den Strom durch den Halbleiterschalter (110) überwacht und den Halbleiterschalter (110) bei Überschreitung der vorbestimmte Grenztemperatur nur dann einschaltet, wenn der überwachte Strom anzeigt, dass der Halbleiterschalter invers betrieben wird.

5. Trennschalter nach einem der Ansprüche 1 bis 4 mit einem Steuersignalausgangsanschluss (S2), an dem ein Steuersignal ausgegeben wird, wenn die Steuerschaltung (120) die Ladungspumpe (130) oder den Halbleiterschalter (110) in Abhängigkeit von der überwachten Temperatur aktiviert.

6. Trennschalter nach einem der Ansprüche 1 bis 5, wobei die Steuerschaltung (120) die Ladungspumpe (130) in Abhängigkeit von der Höhe der Gate-Source-Spannung des Halbleiterschalters (110) aktiviert oder deaktiviert.

7. Trennschalter nach Anspruch 6, wobei die Steuerschaltung (120) die Gate-Spannung des Halbleiterschalters (110) überwacht und die Ladungspumpe (130) aktiviert, wenn die Gate-Spannung unter einen vorbestimmten Minimalwert fällt.

8. Trennschalter nach Anspruch 6 oder 7, wobei die Steuerschaltung (120) die Gate-Spannung des Halbleiterschalters (110) überwacht und die Ladungspumpe (130) deaktiviert, wenn die Gate-Spannung einen vorbestimmten Maximalwert überschreitet.

9. Trennschalter nach einem der Ansprüche 1 bis 8 mit einem Zeitgeber (125), der die Ladungspumpe (130) in Abhängigkeit von der seit der letzten Aktivierung oder Deaktivierung vergangenen Zeit aktiviert oder deaktiviert.

10. Trennschalter nach Anspruch 9, wobei eine Einschaltdauer der Ladungspumpe (130) zumindest so lange gewählt ist, dass der Gate-Anschluss des Halbleiterschalters (110) auf einen vorgegebenen Maximalwert aufgeladen wird.

11. Trennschalter nach Anspruch 9 oder 10, wobei eine Ausschaltdauer der Ladungspumpe (130) höchstens so lange gewählt ist, dass der Gate-Anschluss des Halbleiterschalters (110) auf einen vorgegebenen Minimalwert entladen wird.

12. Trennschalter nach einem der Ansprüche 1 bis 11, wobei die Steuerschaltung (120) die Ladungspumpe (130) in Abhängigkeit von der Höhe der Gate-Spannung des Halbleiterschalters (110) aktiviert und in Abhängigkeit von der seit der letzten Aktivierung vergangenen Zeit deaktiviert.

13. Trennschalter nach einem der Ansprüche 1 bis 12 mit einem Steuersignaleingangsanschluss (S1), wobei die Steuerschaltung (120) den Halbleiterschalter (110) in Abhängigkeit von einem an dem Steuersignaleingangsanschluss (S1) anliegenden Steuersignal ein- und ausschaltet.

14. Trennschalter nach einem der Ansprüche 1 bis 12 mit einem bidirektionalen Steuersignalanschluss (S12), an dem ein Steuersignal ausgegeben wird, wenn die Steuerschaltung (120) die Ladungspumpe (130) oder den Halbleiterschalter (110) in Abhängigkeit von der überwachten Temperatur aktiviert , wobei die Steuerschaltung (120) den Halbleiterschalter (110) in Abhängigkeit von der überwachten Temperatur und einem an dem bidirektionalen Steuersignalanschluss (S12) eingegebenen Steuersignal ein- und ausschaltet.

15. Trennschalter nach einem der Ansprüche 1 bis 14 mit einer Stromversorgungsschaltung (140) zur Versorgung der Ladungspumpe (130) und der Steuerschaltung (120) mit Strom.

16. Trennschalter nach Anspruch 15, wobei ein Eingang der Stromversorgungsschaltung (140) mit dem Drain-Anschluss des Halbleiterschalters (110) verbunden ist.

17. Trennschalter nach Anspruch 15, wobei ein Eingang der Stromversorgungsschaltung (140) mit dem Source-Anschluss des Halbleiterschalters (110) verbunden ist.

18. Trennschalter nach Anspruch 15, wobei ein erster Eingang der Stromversorgungsschaltung (140) mit dem Drain-Anschluss und ein zweiter Eingang der Stromversorgungsschaltung (140) mit dem Source-Anschluss des Halbleiterschalters (110) verbunden ist.

19. Trennschalter nach einem der Ansprüche 1 bis 18 mit einem Eingangsanschluss und einem Ausgangsanschluss, wobei der Halbleiterschalter (110) den Eingangsanschluss mit den Ausgangsanschluss verbindet.

20. Trennschalter nach Anspruch 19, wobei der Drain-Anschluss des Halbleiterschalters (110) direkt mit dem Eingangsanschluss des Trennschalters und der Source-Anschluss des Halbleiterschalters (110) direkt mit dem Ausgangsanschluss des Trennschalters verbunden ist.

21. Trennschalter nach einem der Ansprüche 1 bis 20 mit einem Umschalter, wobei die Steuerschaltung (120) den Gate-Anschluss des Halbleiterschalters (110) über den Umschalter mit der Ladungspumpe (130) verbindet, um den Halbleiterschalter (110) einzuschalten, und den Gate-Anschluss des Halbleiterschalters (110) über den Umschalter mit dem Source-Anschluss des Halbleiterschalters (110) verbindet, um den Halbleiterschalter (110) auszuschalten.

22. Trennschalter nach einem der Ansprüche 1 bis 21, wobei der Halbleiterschalter (110) ein MOSFET ist.

23. Trennschalter nach einem der Ansprüche 1 bis 22, wobei der Halbleiterschalter (110), die Ladungspumpe (130) und die Steuerschaltung (120) in einem gemeinsamen Gehäuse integriert sind.

24. Trennschalter nach einem der Ansprüche 1 bis 23, wobei der Halbleiterschalter (110), die Ladungspumpe (130) und die Steuerschaltung (120) auf einem Chip monolithisch integriert sind.

25. Trennschalter nach einem der Ansprüche 1 bis 22, wobei der Halbleiterschalter (110) einerseits und die Ladungspumpe (130) zusammen mit der Steuerschaltung (120) andererseits auf zwei getrennten Chips in getrennten Gehäusen untergebracht sind.

26. Trennschalter nach Anspruch 25, wobei eine Mehrzahl von Ladungspumpen (130) und Steuerschaltungen (120) auf einem der zwei getrennten Chips integriert sind.

27. Bordnetz für ein Kraftfahrzeug mit einem ersten Bereich und einem davon trennbaren zweiten Bereich (200), wobei
der erste Bereich einen Energiespeicher (E1) umfasst,
der zweite Bereich (200) mit mindestens einem Verbraucher verbunden ist, und
der erste Bereich und der zweite Bereich (200) des Bordnetzes über einen Trennschalter nach einem der Ansprüche 1 bis 26 verbunden sind.

28. Verfahren zur reversiblen Trennung eines Kfz-Bordnetzes in einen ersten Bereich und einen zweiten Bereich (200), wobei der erste Bereich einen Energiespeicher umfasst und der zweite Bereich (200) mit mindestens einem Verbraucher verbunden ist, mit den Schritten
Verbinden des ersten Bereichs mit dem zweiten Bereich (200) über einen Halbleiterschalter (110) und
Erzeugen einer für die Ansteuerung des Halbleiterschalters (110) erforderlichen Gleichspannung mit Hilfe einer Ladungspumpe (130), und
Steuern eines intermittierenden Betriebs der Ladungspumpe (130) durch wechselweises Aktivieren und Deaktivieren der Ladungspumpe (130),
**gekennzeichnet durch**
Überwachen der Temperatur des Halbleiterschalters (110), wobei der Steuerschritt dazu eingerichtet ist, die Ladungspumpe (130) in Abhängigkeit von der überwachten Temperatur zu aktivieren, wobei die Ladungspumpe aktiviert wird wenn eine vorbestimmte Grenztemperatur überschritten wird.

## Claims

1. Disconnector for a vehicle on-board network with a semiconductor switch (110) and
a charge pump (130) for generating a DC voltage required for driving the semiconductor switch, and
a control circuit (120) for controlling an intermittent operation of the charge pump (130) by alternately switching the charge pump (130) on and off,
**characterised by**
a temperature sensor (160) for monitoring the temperature of the semiconductor switch (110), wherein the control circuit (120) is adapted to switch on the charge pump (130) in response to the monitored temperature, the charge pump being switched on when a predetermined threshold temperature is exceeded.

2. A circuit breaker according to claim 1, wherein the control circuit (120) switches the charge pump (130) when a predetermined threshold temperature is exceeded.

3. A circuit breaker according to claim 2, wherein the control circuit (120) switches on the semiconductor switch (110) when the predetermined threshold temperature is exceeded.

4. A circuit breaker according to claim 3, wherein the control circuit (120) additionally monitors the current through the semiconductor switch (110) and turns on the semiconductor switch (110) when the predetermined threshold temperature is exceeded only when the monitored current indicates that the semiconductor switch is inversely operating.

5. A circuit breaker according to any one of claims 1 to 4, comprising a control signal output terminal (S2) at which a control signal is output when the control circuit (120) turns on the charge pump (130) or the semiconductor switch (110) in response to the monitored temperature.

6. A circuit breaker according to any one of claims 1 to 5, wherein the control circuit (120) turns the charge pump (130) on and off on the basis of the level of the gate-source voltage of the semiconductor switch (110).

7. A circuit breaker according to claim 6, wherein the control circuit (120) monitors the gate voltage of the semiconductor switch (110) and turns on the charge pump (130) when the gate voltage falls below a predetermined minimum value.

8. A circuit breaker according to claim 6 or 7, wherein the control circuit (120) monitors the gate voltage of the semiconductor switch (110) and turns off the charge pump (130) when the gate voltage exceeds a predetermined maximum value.

9. A circuit breaker according to any one of claims 1 to 8, comprising a timer (125) which turns the charge pump (130) on and off in response to the time elapsed since the last activation or deactivation.

10. A circuit breaker according to claim 9, wherein a duty cycle of the charge pump (130) is at least selected so long as the gate terminal of the semiconductor switch (110) is charged to a predetermined maximum value.

11. A circuit breaker according to claim 9 or 10, wherein a turn-off duration of the charge pump (130) is at most selected as long as the gate terminal of the semiconductor switch (110) is emptied to a predetermined minimum value.

12. A circuit breaker according to one of the claims 1 to 11, wherein the control circuit (120) turns on the charge pump (130) on the basis of the level of the gate voltage of the semiconductor switch (110) and turns it off on the basis of the time elapsed since the last activation.

13. A circuit breaker according to any one of claims 1 to 12, comprising a control signal input terminal (S1), the control circuit (120) turning on and off the semiconductor switch (110) in response to a control signal applied to the control signal input terminal (S1).

14. A circuit breaker according to one of claims 1 to 12 with a bidirectional control signal terminal (S12), on which a control signal is output,
when the control circuit (120) turns on the charge pump (130) or the semiconductor switch (110) in response to the monitored temperature, wherein the control circuit (120) turns the semiconductor switch (110) on and off in response to the monitored temperature and a control signal input to the bidirectional control signal terminal (S12).

15. A circuit breaker according to any one of claims 1 to 14, comprising a power supply circuit (140) for supplying the charge pump (130) and the control circuit (120) with power.

16. A circuit breaker of claim 15, wherein an input of the power supply circuit (140) is connected to the drain terminal of the semiconductor switch (110).

17. A circuit breaker of claim 15, wherein an input of the power supply circuit (140) is connected to the source terminal of the semiconductor switch (110).

18. A circuit breaker of claim 15, wherein a first input of the power supply circuit (140) is connected to the drain terminal and a second input of the power supply circuit (140) is connected to the source terminal of the semiconductor switch (110).

19. A circuit breaker according to any one of claims 1 to 18, having an input terminal and an output terminal, wherein the semiconductor switch (110) connects the input terminal to the output terminal.

20. A circuit breaker of claim 19, wherein the drain terminal of the semiconductor switch (110) is directly connected to the input terminal of the circuit breaker and the source terminal of the semiconductor switch (110) is directly connected to the output terminal of the circuit breaker.

21. A circuit breaker according to one of claims 1 to 20 with a switch, wherein the control circuit (120) connects the gate terminal of the semiconductor switch (110) via the switch with the charge pump (130), to turn on the semiconductor switch (110) and connects the gate terminal of the semiconductor switch (110) via the switch to the source terminal of the semiconductor switch (110) to turn off the semiconductor switch (110).

22. A circuit breaker according to any one of claims 1 to 21, wherein the semiconductor switch (110) is a MOSFET.

23. A circuit breaker according to one of the claims 1 to 22, wherein the semiconductor switch (110), the charge pump (130) and the control circuit (120) are integrated in a common housing.

24. A circuit breaker according to one of the claims 1 to 23, wherein the semiconductor switch (110), the charge pump (130) and the control circuit (120) are integrated on a chip monolithically.

25. A circuit breaker according to one of the claims 1 to 22, wherein the semiconductor switch (110) on the one hand and the charge pump (130) together with the control circuit (120) on the other hand are housed on two separate chips in separate housings.

26. A circuit breaker according to claim 25, wherein a plurality of charge pumps (130) and control circuits (120) are integrated on one of the two separate chips.

27. A vehicle electrical system for a motor vehicle having a first area and a second area (200) separable therefrom, wherein
the first region comprises an energy storage device (E1),
the second region (200) is connected to at least one consumer device, and
the first region and the second region (200) of the vehicle electrical system are connected via a circuit breaker according to one of claims 1 to 26.

28. A method for the reversible separation of a motor vehicle electrical system into a first region and a second region (200), wherein the first region comprises an energy storage device and the second region (200) is connected to at least one consumer device, with the steps
connecting the first region to the second region (200) via a semiconductor switch (110) and
generating a DC voltage required for driving the semiconductor switch (110) by means of a charge pump (130), and
controlling an intermittent operation of the charge pump (130) by alternately switching the charge pump (130) on and off,
**characterised by**
monitoring the temperature of the semiconductor switch (110), wherein the control circuit (120) is adapted to switch on the charge pump (130) in response to the monitored temperature, the charge pump being switched on when a predetermined threshold temperature is exceeded.

## Revendications

1. Disjoncteur pour système électrique embarqué avec un interrupteur à semi-conducteur (110) et
une pompe de charge (130) pour générer une tension continue nécessaire à la commande de l'interrupteur à semi-conducteur, et
un circuit de commande (120) pour commander un fonctionnement intermittent de la pompe de charge (130) en actionnant et inhibant alternativement la pompe de charge (130),
**caractérisé par**
un capteur de température (160) pour surveiller la température de l'interrupteur à semi-conducteur (110), dans lequel le circuit de commande (120) est conçu pour mettre en marche la pompe de charge (130) en fonction de la température surveillée, la pompe de charge étant activée en cas de dépassement d'un seuil de température.

2. Disjoncteur selon la revendication 1, dans lequel le circuit de commande (120) met en marche la pompe de charge (130) en cas de dépassement d'un seuil de température.

3. Disjoncteur selon la revendication 2, dans lequel le circuit de commande (120) active l'interrupteur à semi-conducteur (110) en cas de dépassement du seuil de température.

4. Disjoncteur selon la revendication 3, dans lequel le circuit de commande (120) surveille en outre le courant à travers l'interrupteur à semi-conducteur (110) et n'active l'interrupteur à semi-conducteur (110) qu'en cas de dépassement de la température limite prédéterminée, lorsque le courant surveillé indique que l'interrupteur à semi-conducteur est actionné dans le sens inverse.

5. Disjoncteur selon l'une quelconque des revendications 1 à 4, comprenant une borne de sortie de signal de commande (S2) à laquelle un signal de commande est émis lorsque le circuit de commande (120) active la pompe de charge (130) ou l'interrupteur à semi-conducteur (110) en réponse à la température surveillée.

6. Disjoncteur selon l'une des revendications 1 à 5, dans lequel le circuit de commande (120) actionne et éteint la pompe de charge (130) en fonction du niveau de la tension grille-source de l'interrupteur à semi-conducteur (110).

7. Disjoncteur selon la revendication 6, dans lequel le circuit de commande (120) surveille la tension de grille de l'interrupteur à semi-conducteur (110) et actionne la pompe de charge (130) lorsque la tension de grille tombe en dessous d'une valeur minimale prédéterminée.

8. Disjoncteur selon les revendications 6 ou 7, dans lequel le circuit de commande (120) surveille la tension de grille de l'interrupteur à semi-conducteur (110) et éteint la pompe de charge (130) lorsque la tension de grille dépasse une valeur maximale prédéterminée.

9. Disjoncteur selon l'une quelconque des revendications 1 à 8, comprenant une minuterie (125) qui actionne et éteint la pompe de charge (130) en réponse au temps écoulé depuis la dernière activation ou désactivation.

10. Disjoncteur selon la revendication 9, dans lequel un cycle de fonctionnement de la pompe de charge (130) est au moins sélectionné tant que la borne de grille de l'interrupteur à semi-conducteur (110) est chargée à une valeur maximale prédéterminée.

11. Disjoncteur selon les revendications 9 ou 10, dans lequel une durée de désactivation de la pompe de charge (130) est au plus sélectionnée tant que la borne de grille de l'interrupteur à semi-conducteur (110) est déchargée à une valeur minimale prédéterminée.

12. Disjoncteur selon l'une des revendications 1 à 11, dans lequel le circuit de commande (120) met en marche la pompe de charge (130) en fonction du niveau de la tension de grille de l'interrupteur à semi-conducteur (110) et l'éteint en fonction du temps écoulé depuis la dernière activation.

13. Disjoncteur selon l'une quelconque des revendications 1 à 12, comprenant une borne d'entrée de signal de commande (S1), le circuit de commande (120) activant et désactivant l'interrupteur à semi-conducteur (110) en fonction d'un signal de commande appliqué à la borne d'entrée de signal de commande (S1).

14. Disjoncteur selon l'une des revendications 1 à 12 avec une borne de signal de commande bidirectionnelle (S12) sur laquelle est émis un signal de commande,
lorsque le circuit de commande (120) met en marche la pompe de charge (130) ou l'interrupteur à semi-conducteur (110) en fonction de la température surveillée, dans lequel le circuit de commande (120) allume et éteint l'interrupteur à semi-conducteur (110) en fonction de la température surveillée et d'un signal de commande saisi dans la borne de signal de commande bidirectionnelle (S12).

15. Disjoncteur selon l'une quelconque des revendications 1 à 14, comprenant un circuit d'alimentation (140) destiné à alimenter la pompe de charge (130) et le circuit de commande (120).

16. Disjoncteur selon la revendication 15, dans lequel une entrée du circuit d'alimentation (140) est connectée à la borne de drain de l'interrupteur à semi-conducteur (110).

17. Disjoncteur selon la revendication 15, dans lequel une entrée du circuit d'alimentation (140) est connectée à la borne de source de l'interrupteur à semi-conducteur (110).

18. Disjoncteur selon la revendication 15, dans lequel une première entrée du circuit d'alimentation (140) est connectée à la borne de drain et une seconde entrée du circuit d'alimentation (140) est connectée à la borne de source de l'interrupteur à semi-conducteur (110).

19. Disjoncteur selon l'une quelconque des revendications 1 à 18, comportant une borne d'entrée et une borne de sortie, dans lequel l'interrupteur à semi-conducteur (110) connecte la borne d'entrée à la borne de sortie.

20. Disjoncteur selon la revendication 19, dans lequel la borne de drain de l'interrupteur à semi-conducteur (110) est reliée directement à la borne d'entrée du disjoncteur et la borne de source de l'interrupteur semi-conducteur (110) est directement connectée à la borne de sortie du disjoncteur.

21. Disjoncteur selon l'une quelconque des revendications 1 à 20 avec un interrupteur, dans lequel le circuit de commande (120) relie la borne de grille de l'interrupteur à semi-conducteur (110) par le biais de l'interrupteur avec la pompe de charge (130), pour actionner l'interrupteur à semi-conducteur (110) et relie la borne de grille de l'interrupteur à semi-conducteur (110) par le biais de l'interrupteur à la borne de source de l'interrupteur à semi-conducteur (110) pour inhiber l'interrupteur à semi-conducteur (110).

22. Disjoncteur selon l'une quelconque des revendications 1 à 21, dans lequel l'interrupteur à semi-conducteur (110) est un MOSFET.

23. Disjoncteur selon l'une des revendications 1 à 22, dans lequel l'interrupteur à semi-conducteur (110), la pompe de charge (130) et le circuit de commande (120) sont intégrés dans un boîtier commun.

24. Disjoncteur selon l'une des revendications 1 à 23, dans lequel l'interrupteur à semi-conducteur (110), la pompe de charge (130) et le circuit de commande (120) sont intégrés sur une puce de manière monolithique.

25. Disjoncteur selon l'une des revendications 1 à 22, dans lequel l'interrupteur à semi-conducteur (110) d'une part et la pompe de charge (130) ainsi que le circuit de commande (120) d'autre part sont logés sur deux puces séparées dans des boîtiers séparés.

26. Disjoncteur selon la revendication 25, dans lequel une pluralité de pompes de charge (130) et de circuits de commande (120) sont intégrés sur l'une des deux puces séparées.

27. Système électrique embarqué pour véhicule automobile ayant une première zone et une seconde zone (200) séparable de celle-ci, dans lequel
la première zone comprend un dispositif de stockage d'énergie (E1),
la seconde zone (200) est connectée à au moins un dispositif consommateur, et
la première zone et la deuxième zone (200) du système électrique embarqué sont connectées par le biais d'un disjoncteur selon l'une des revendications 1 à 26.

28. Procédé de séparation réversible d'un système électrique embarqué de véhicule automobile en une première zone et une seconde zone (200), la première zone comprenant un dispositif de stockage d'énergie et la seconde zone (200) étant connectée à au moins un dispositif consommateur, avec les étapes suivantes:
connecter la première zone à la deuxième zone (200) par le biais d'un commutateur à semi-conducteur (110) et
générer une tension continue nécessaire à la commande de l'interrupteur à semi-conducteur (110) au moyen d'une pompe de charge (130), et
commander un fonctionnement intermittent de la pompe de charge (130) en actionnant et inhibant alternativement la pompe de charge (130),
**caractérisé par**
surveiller la température de l'interrupteur à semi-conducteur (110), dans lequel le circuit de commande (120) est conçu pour mettre en marche la pompe de charge (130) en fonction de la température surveillée, la pompe de charge étant activée en cas de dépassement d'un seuil de température.
